(19) Europäisches Patentamt
European Patent Office
Office européen des brevets

(11) EP 1 171 502 B2

(12) NEW EUROPEAN PATENT SPECIFICATION
After opposition procedure

(45) Date of publication and mention of the opposition decision:
**05.07.2017 Bulletin 2017/27**

(45) Mention of the grant of the patent:
**13.06.2007 Bulletin 2007/24**

(21) Application number: **00921184.8**

(22) Date of filing: **19.04.2000**

(51) Int Cl.:
*C08F 255/00* (2006.01) *C08G 59/24* (2006.01)
*C08F 257/02* (2006.01) *C08G 59/00* (2006.01)
*C08F 279/02* (2006.01) *C08F 287/00* (2006.01)
*C08G 59/68* (2006.01) *C08G 65/10* (2006.01)
*C08G 65/18* (2006.01) *C08L 51/00* (2006.01)
*C08L 51/04* (2006.01) *C08L 51/06* (2006.01)
*C08L 71/02* (2006.01) *G03F 7/00* (2006.01)
*G03F 7/027* (2006.01) *G03F 7/038* (2006.01)

(86) International application number:
**PCT/NL2000/000256**

(87) International publication number:
**WO 2000/063272 (26.10.2000 Gazette 2000/43)**

# (54) RESIN COMPOSITION FOR PHOTOFABRICATION OF THREE DIMENSIONAL OBJECTS

HARZZUSAMMENSETZUNG ZUR PHOTO-HERSTELLUNG DREIDIMENSIONALER GEGENSTÄNDE

COMPOSITION DE RESINE POUR LA FABRICATION PAR PHOTO-INCISION D'OBJETS TRIDIMENSIONNELS

(84) Designated Contracting States:
**AT BE CH CY DE DK ES FI FR GB GR IE IT LI LU MC NL PT SE**

(30) Priority: **19.04.1999 JP 11144599**

(43) Date of publication of application:
**16.01.2002 Bulletin 2002/03**

(73) Proprietors:
- **DSM IP Assets B.V.**
  **6411 TE Heerlen (NL)**
- **JSR Corporation**
  **Tokyo 104-0045 (JP)**
- **Japan Fine Coatings Co., Ltd.**
  **Tokyo 104-8410 (JP)**

(72) Inventors:
- **YAMAMURA, Tetsuya**
  **Ibaraki 305 (JP)**
- **KATO, Yukitoshi**
  **Ibaraki 300-0033 (JP)**
- **TANABE, Toyokazu**
  **Shinnanyo-shi**
  **Yamaguchi (JP)**
- **UKACHI, Takashi**
  **Ushiku**
  **Ibaraki 300-12 (JP)**

(74) Representative: **V.O.**
**P.O. Box 87930**
**2508 DH Den Haag (NL)**

(56) References cited:

| | |
|---|---|
| **EP-A- 0 848 292** | **EP-A- 0 848 293** |
| **EP-A- 0 848 294** | **EP-A- 0 938 026** |
| **EP-A1- 0 203 828** | **EP-A1- 0 848 294** |
| **EP-A1- 0 938 026** | **EP-A2- 0 449 776** |
| **WO-A-97/38354** | **WO-A1-00/63272** |
| **WO-A1-97/38354** | **JP-A- H10 158 581** |
| **JP-A- H10 212 343** | **JP-A- H11 144 599** |



Printed by Jouve, 75001 PARIS (FR)

## Description

The present invention relates to a photocurable resin composition for photofabrication of three-dimensional objects which can produce a cured product exhibiting superior photocurability and excellent mechanical strength. More particularly, the present invention relates to a photocurable resin composition for photofabrication of three-dimensional objects which exhibits superior photocurability to various light sources such as a laser and a UV lamp and can produce a cured three-dimensional object exhibiting superior folding endurance, and to a fabricated object produced by photocuring the composition.

In recent years, photofabrication of three-dimensional object consisting of cured resin layers integrally laminated by repeating a step of selectively irradiating a photocurable liquid resin composition has been proposed (see Japanese Patent Application Laid-open Nos. 247515/1985, 35966/1987, 101408/1987, and 24119/1993).

A typical example of such photofabrication is as follows. The surface of a photocurable resin composition in a vessel is selectively irradiated with light from an ultraviolet laser and the like to form a cured resin layer having a specified pattern. The equivalent of one layer of a photocurable resin composition is provided over this cured resin layer and the liquid surface is selectively irradiated to form a newly cured resin layer integrally laminated over the cured resin layer. This step is repeated a certain number of times using the same or different irradiating patterns to obtain a three-dimensional object consisting of integrally laminated cured resin layers. This photofabrication has attracted considerable attention because a three-dimensional object having a complicated shape can be easily formed in a short period of time.

As the photocurable resin composition used in the photofabrication of three-dimensional objects, the following resin compositions (a) to (c) have been known in the art.

(a) A resin composition comprising a radically polymerizable organic compound such as urethane (meth)acrylate, oligoester (meth)acrylate, epoxy (meth)acrylate, and photosensitive polyimide (see Japanese Patent Applications Laid-open Nos. 204915/1989, 208305/1990, and 160013/1991).

(b) A resin composition comprising a cationically polymerizable organic compound such as an epoxy compound, cyclic ether compound, cyclic lactone compound, cyclic acetal compound, cyclic thioether compound, spiro orthoester compound, and vinyl ether compound (see Japanese Patent Application Laid-open No. 213304/1989).

(c) A resin composition comprising both the radically polymerizable organic compound and the cationically polymerizable organic compound (see Japanese Patent Applications Laid-open Nos. 28261/1990, 75618/1990, and 228413/1994).

In view of efficiency of photofabrication, the photocurable resin compositions used for the photofabrication preferably possesses low viscosity for immediately forming a smooth liquid surface as well as superior curability to be cured immediately by irradiation. Moreover, the photocurable resin compositions are required to exhibit a small amount of deformation such as warping caused by shrinkage during photocuring.

Three-dimensional objects produced by the photofabrication are used for design models, prototypes for mechanical parts, and the like. Therefore, such three-dimensional objects have to be formed with highly accurate fabrication, specifically, provided with accurate micro-fabrication conforming to the plan, exhibit sufficient mechanical strength under use conditions, and have stable mechanical characteristics which do not change with time.

The three-dimensional objects formed from the photocurable resin composition have been widely used in various fields in satisfying various requirements, for example, fabrication accuracy, hardness, sufficient elasticity, and a small amount of warping caused by cure shrinkage of the liquid resin. It has been thought to be difficult to provide toughness to the fabricated object formed from the photocurable resins because of characteristics of the photocurable resins. However, three-dimensional objects exhibiting toughness, in particular, folding endurance have been demanded accompanying the expansion of the market. A blend of fine particles with the resin composition has been attempted in order to improve physical properties of the three-dimensional product. Such attempts aim at increasing fabrication accuracy (see Japanese Patent Application Laid-open No. 114733/1991), adjusting light scattering of the fabricated product (see Japanese Patent Application Laid-open No. 103415/1991), improving toughness of the fabricated object (Japanese Patent Application Laid-open No. 145616/1990), and the like. However, these inventions do not aim at overcoming a shortcoming of the three-dimensional object of being inferior in repeated folding deformation and have not solved this problem.

The present invention has been achieved based on the above situation.

An object of the present invention is to provide a novel photocurable resin composition for the photofabrication of three-dimensional objects.

A second object of the present invention is to provide a photocurable resin composition for photofabrication of three-dimensional objects capable of producing a three-dimensional object which exhibits superior mechanical strength, high fabrication accuracy, a small amount of warping, and excellent folding endurance, and which is suitably used in prototypes for mechanical parts and the like.

A third object of the present invention is to provide a three-dimensional object exhibiting superior folding endurance and a small variation in modulus of elasticity with time.

Other objects, features and advantages of the invention will hereinafter become more readily apparent from the following description.

First, according to the present invention, the above objects and advantages can be achieved by a photocurable resin composition for photofabrication of three-dimensional objects as defined in claim 1.

According to the present invention, the above objects and advantages can be achieved by a fabricated object produced by photocuring the photocurable resin composition of the present invention.

Oxetane compound (A)

An oxetane compound (A) (hereinafter may be called "component (A)") which constitutes the photocurable resin composition for photofabrication of three-dimensional objects of the present invention (hereinafter may be called "resin composition") comprises at least one oxetane ring shown by the following formula (1).

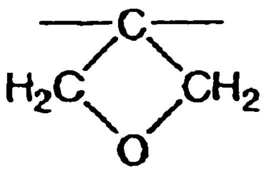

(1)

The oxetane compound can be polymerised or crosslinked by irradiation with light in the presence of a cationically polymerizable photoinitiator.

Oxetane compound (A) comprises at least one oxetane ring. Examples of compound (A) are given below.

Examples of compound (A) having one oxetane ring in the molecule, are shown by the following formula (2):

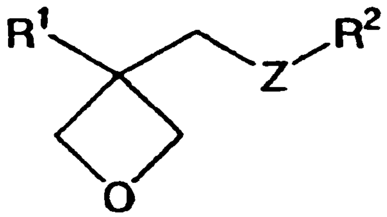

(2)

wherein Z represents an oxygen atom or sulphur atom; $R^1$ represents a hydrogen atom, fluorine atom, an alkyl group having 1-6 carbon atoms such as a methyl group, ethyl group, propyl group, and butyl group, a fluoroalkyl group having 1-6 carbon atoms such as trifluoromethyl group, perfluoroethyl group, and perfluoropropyl group, an aryl group having 6-18 carbon atoms such as a phenyl group and naphthyl group, a furyl group, or a thienyl group; and $R^2$ represents a hydrogen atom, an alkyl group having 1-6 carbon atoms for example a methyl group, ethyl group, propyl group, and butyl group, an alkenyl group having 2-6 carbon atoms for example a 1-propenyl group, 2-propenyl group, 2-methyl-1-propenyl group, 2-methyl-2-propenyl group, 1-butenyl group, 2-butenyl group, and 3-butenyl group, an aryl group having 6-18 carbon atoms for example a phenyl group, naphthyl group, anthranyl group, and phenanthryl group, a substituted or unsubstituted aralkyl group having 7-18 carbon atoms for example a benzyl group, fluorobenzyl group, methoxy benzyl group, phenethyl group, styryl group, cynnamyl group, ethoxybenzyl group, a group having other aromatic rings for instance an aryloxyalkyl for example a phenoxymethyl group and phenoxyethyl group, an alkylcarbonyl group having 2-6 carbon atoms for example an ethylcarbonyl group, propylcarbonyl group, butylcarbonyl group, an alkoxy carbonyl group having 2-6 carbon atoms for example an ethoxycarbonyl group, propoxycarbonyl group, butoxycarbonyl group, an N-alkylcarbamoyl group having 2-6 carbon atoms such as an ethylcarbamoyl group, propylcarbamoyl group, butylcarbamoyl group, pentylcarbamoyl group.

As examples of compounds having two oxetane rings in the molecule, compounds shown by the following formula (3) can be given:

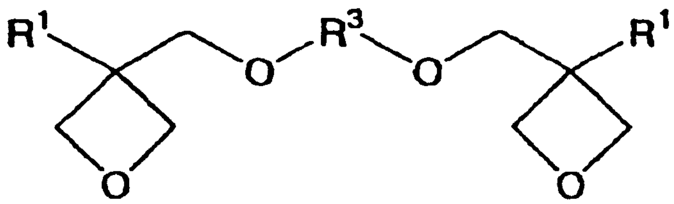

(3)

wherein $R^1$ is the same as defined for the above formula (2); $R^3$ represents a linear or branched alkylene group having 1-20 carbon atoms for example an ethylene group, propylene group, and butylene group, a linear or branched poly(alkyleneoxy) group having 1-120 carbon atoms for example a poly(ethyleneoxy) group and poly(propyleneoxy) group, a linear or branched unsaturated hydrocarbon group for example a propenylene group, methylpropenylene group, and butenylene group, a carbonyl group, an alkylene group containing a carbonyl group, an alkylene group containing a carboxyl group in the middle of the molecular chain, and an alkylene group containing a carbamoyl group in the middle of the molecular chain; and $R^3$ may be a polyvalent group selected from groups shown by the following formulas (4), (5), and (6) :

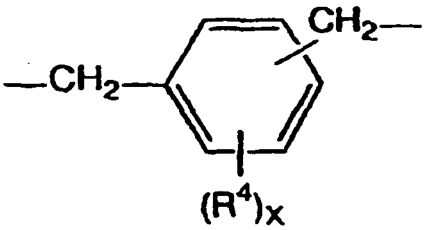

(4)

wherein $R^4$ represents an alkyl group having 1-4 carbon atoms, an alkoxy group having 1-4 carbon atoms, a halogen atom for example a chlorine atom or bromine atom, a nitro group, cyano group, mercapto group, carboxyl group, or carbamoyl group, and x is an integer from 1-4;

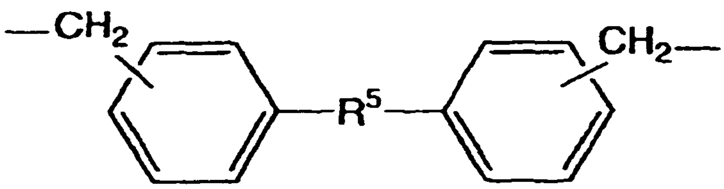

(5)

wherein $R^5$ represents an oxygen atom, sulphur atom, methylene group, -NH-, -SO-, -SO2-, -C(CF3)2-, or -C(CH3)2-;

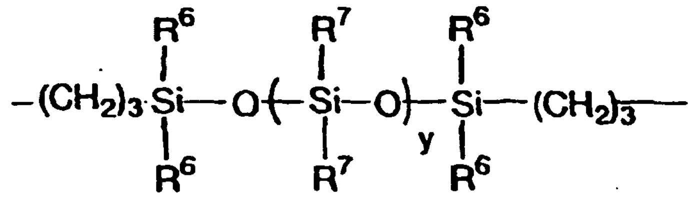

(6)

wherein $R^6$ represents an alkyl group having 1-4 carbon atoms or an aryl group having 6-18 carbon atoms for example a phenyl group or naphthyl group, y is an integer from 0-200, and $R^7$ represents an alkyl group having 1-4 carbon atoms, an aryl group having 6-18 carbon atoms for example a phenyl group or naphthyl group, or a group shown by the following formula (7):

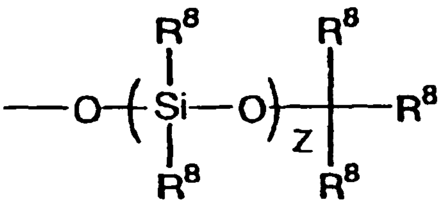

(7)

wherein $R^8$ represents an alkyl group having 1-4 carbon atoms or an aryl group having 6-18 carbon atoms for example a phenyl group or naphthyl group, and z is an integer from 0-100.

As specific examples of the compounds having two oxetane rings in the molecule, compounds shown by the following formulas (8), (9), and (10) can be given.

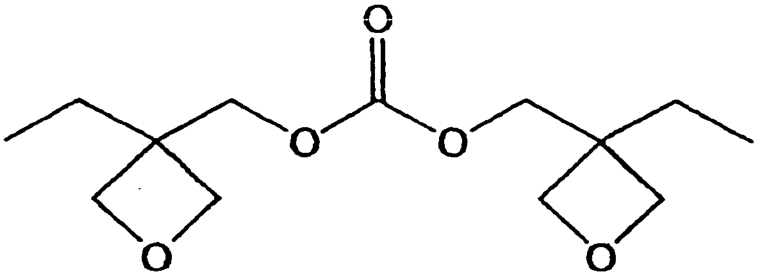

(8)

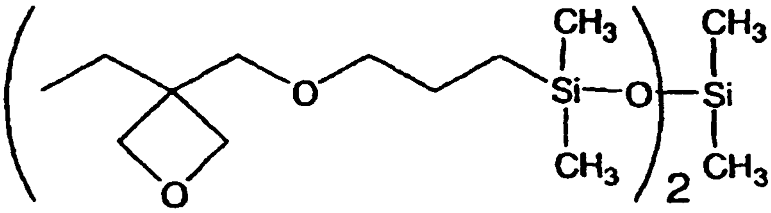

(9)

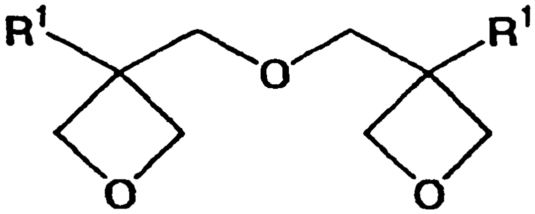

(10)

In the formula (10), $R^1$ is the same as defined for the above formula (2).

As examples of the compounds having three or more oxetane rings in the molecule, compounds shown by the following formula (11) can be given:

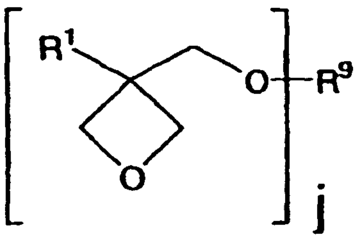

(11)

wherein $R^1$ is the same as defined for the above formula (2); $R^9$ represents an organic group with a valence of 3-10, for example, a branched or linear alkylene group having 1-30 carbon atoms for example groups shown by the following formulas (12)-(14), a branched poly(alkyleneoxy) group for example a group shown by the following formula (15), or a linear or branched polysiloxane containing group shown by the following formula (16) or (17),; j is an integer from 3-10 which is equal to the valence of $R^9$:

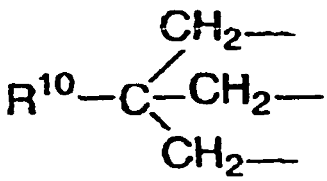

(12)

wherein $R^{10}$ represents an alkyl group having 1-6 carbon atoms:

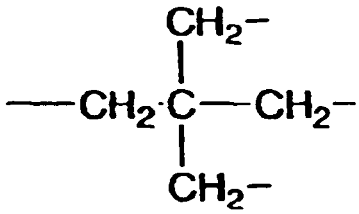

(1 3)

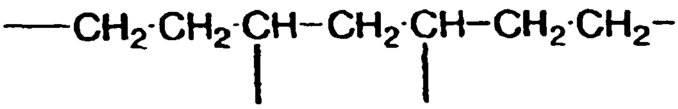

(1 4)

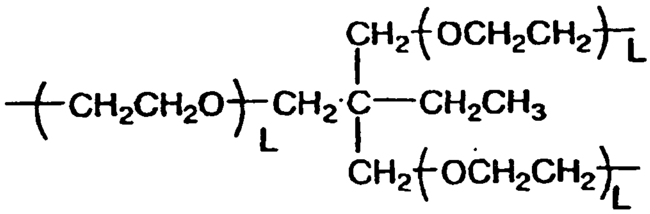

(1 5)

wherein each L is individually an integer from 1-10.

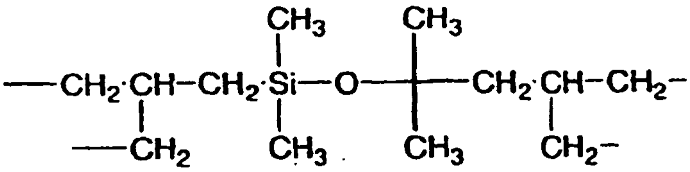

(1 6)

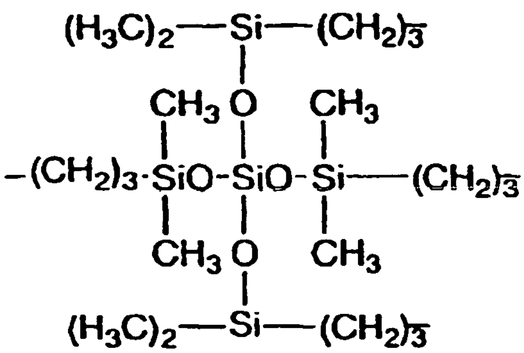

(1 7)

As specific examples of compounds having three or more oxetane rings in the molecule, compounds shown by the following formula (18) can be given.

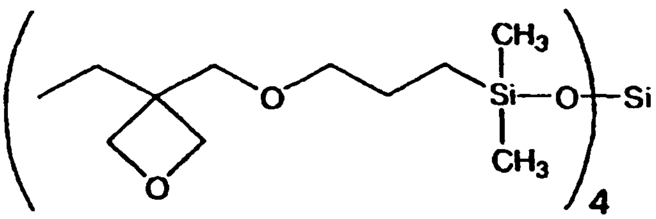

(1 8)

Compounds shown by the following formula (19) may comprise 1-10 oxetane rings:

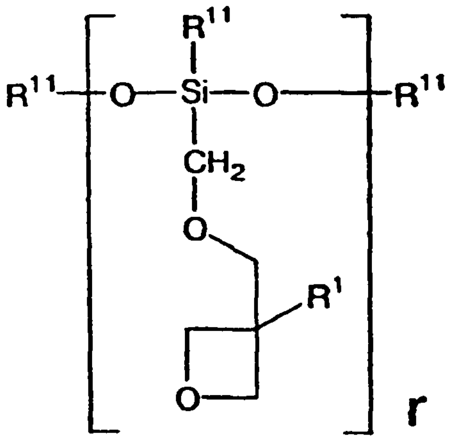

(19)

wherein $R^1$ is the same as defined for the formula (2), $R^8$ is the same as defined for the formula (7), $R^{11}$ represents an alkyl group having 1-4 carbon atoms or trialkylsilyl group (wherein each alkyl group individually is an alkyl group having 1-12 carbon atom), for example a trimethylsilyl group, triethylsilyl group, tripropylsilyl group, or tributylsilyl group, and r is an integer from 1-10.

Furthermore, other than the above-mentioned compounds, compounds having a polystyrene-reduced number average molecular weight measured by gel permeation chromatography of 1,000-5,000 can be given as examples of the oxetane compound (A). As examples of such compounds, compounds shown by the following formulas (20), (21), and (22) can be given:

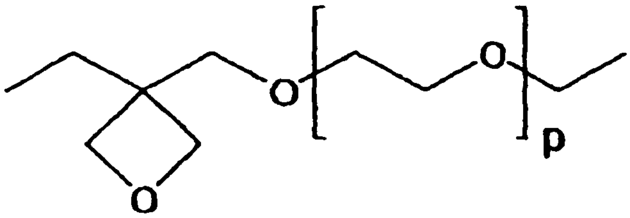

(20)

wherein p is an integer from 20-200:

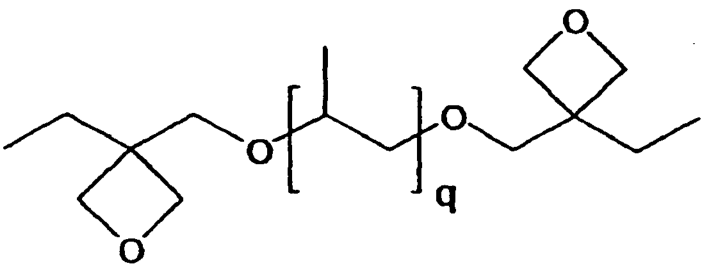

(21)

wherein q is an integer from 15-100:

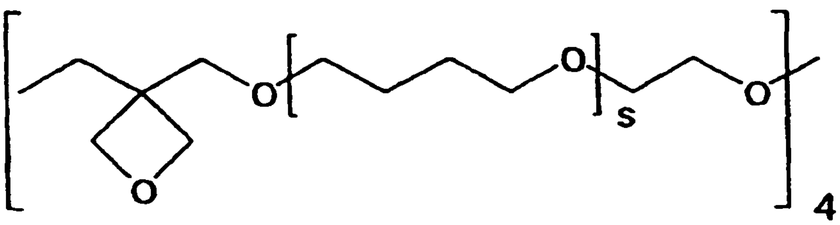

(22)

wherein s is an integer from 20-200.

Specific examples of the above-described oxetane compound (A) are given below.

Compounds containing one oxetane ring in the molecule:

3-ethyl-3-hydroxymethyloxetane, 3-(meth)allyloxymethyl-3-ethyloxetane, (3-ethyl-3-oxetanylmethoxy)methylbenzen, 4-fluoro-[1-(3-ethyl-3-oxetanylmethoxy)methyl]benzene, 4-methoxy-[1-(3-ethyl-3-oxetanylmethoxy)methyl]benzene, [1-(3-ethyl-3-oxetanylmethoxy)ethyl] phenyl ether, isobutoxymethyl (3-ethyl-3-oxetanylmethyl) ether, isobornyloxyethyl (3-ethyl-3-oxetanylmethyl) ether, isobornyl (3-ethyl-3-oxetanylmethyl) ether, 2-ethylhexyl (3-ethyl-3-oxetanyl methyl) ether, ethyldiethylene glycol (3-ethyl-3-oxetanylmethyl) ether, dicyclopentadiene (3-ethyl-3-oxetanylmethyl) ether, dicyclopentenyloxyethyl (3-ethyl-3-oxetanyl methyl) ether, dicyclopentenyl (3-ethyl-3-oxetanylmethyl) ether, tetrahydrofurfuryl (3-ethyl-3-oxetanylmethyl) ether, tetrabromophenyl (3-ethyl-3-oxetanylmethyl) ether, 2-tetrabromophenoxyethyl (3-ethyl-3-oxetanylmethyl) ether, tribromophenyl (3-ethyl-3-oxetanylmethyl) ether, 2-tribromophenoxyethyl (3-ethyl-3-oxetanylmethyl) ether, 2-hydroxyethyl (3-ethyl-3-oxetanyl methyl) ether, 2-hydroxypropyl (3-ethyl-3-oxetanylmethyl) ether, butoxyethyl (3-ethyl-3-oxetanylmethyl) ether, pentachlorophenyl (3-ethyl-3-oxetanylmethyl) ether, pentabromophenyl (3-ethyl-3-oxetanylmethyl) ether, bornyl (3-ethyl-3-oxetanylmethyl) ether.

Compounds containing two or more oxetane rings in the molecule:

3,7-bis(3-oxetanyl)-5-oxa-nonane, 3,3'-(1,3-(2-methylenyl)propanediylbis(oxymethylene))bis-(3-ethyloxetane), 1,4-bis[(3-ethyl-3-oxetanylmethoxy)methyl]benzene, 1,2-bis[(3-ethyl-3-oxetanylmethoxy)methyl]ethane, 1,3-bis[(3-ethyl-3-oxetanylmethoxy)methy]propane, ethylene glycol bis(3-ethyl-3-oxetanylmethyl) ether, dicyclopentenyl bis(3-ethyl-3-oxetanylmethyl) ether, triethylene glycol bis(3-ethyl-3-oxetanylmethyl) ether, tetraethylene glycol bis(3-ethyl-3-oxetanylmethyl) ether, tricyclodecanediyldimethylene (3-ethyl-3-oxetanylmethyl) ether, trimethylolpropane tris(3-ethyl-3-oxetanylmethyl) ether, 1,4-bis(3-ethyl-3-oxetanylmethoxy)butane, 1,6-bis(3-ethyl-3-oxetanylmethoxy)hexane, pentaerythritol tris(3-ethyl-3-oxetanylmethyl) ether, pentaerythritol tetrakis(3-ethyl-3-oxetanylmethyl) ether, polyethylene glycol bis(3-ethyl-3-oxetanylmethyl) ether, dipentaerythritol hexakis(3-ethyl-3-oxetanylmethyl) ether, dipentaerythritol pentakis(3-ethyl-3-oxetanylmethyl) ether, dipentaerythritol tetrakis(3-ethyl-3-oxetanylmethyl) ether, caprolactone-modified dipentaerythritol hexakis(3-ethyl-3-oxetanylmethyl) ether, caprolactone-modified dipentaerythritol pentakis(3-ethyl-3-oxetanylmethyl) ether, ditrimethylolpropane tetrakis(3-ethyl-3-oxetanylmethyl) ether, EO-modified bisphenol A bis(3-ethyl-3-oxetanylmethyl) ether, PO-modified bisphenol A bis(3-ethyl-3-oxetanylmethyl) ether, EO-modified hydrogenated bisphenol A bis(3-ethyl-3-oxetanylmethyl) ether, PO-modified hydrogenated bisphenol A bis(3-ethyl-3-oxetanylmethyl) ether, EO-modified bisphenol F (3-ethyl-3-oxetanylmethyl) ether. These compounds can be used either individually or in combination of two or more.

Of these, oxetane compounds having 1-10, preferably 1-4, and particularly preferably two oxetane rings in the molecule are suitable as the component (A) of the resin composition of the present invention. Most preferred examples of compound (A) are, (3-ethyl-3-oxetanylmethoxy)methylbenzene shown by the following formula (23), 1,4-bis[(3-ethyl-3-oxetanylmethoxy)methyl]benzene shown by the following formula (24), 1,2-bis(3-ethyl-3-oxetanylmethoxy)ethane shown by the following formula (25), trimethylolpropane tris(3-ethyl-3-oxetanylmethyl) ether shown by the following formula (26), 3-ethyl-3-oxetanylmethoxybenzene shown by the following formula (27), and the compound shown by the above formula (19), which compounds can be used either individually in combinations of two or more.

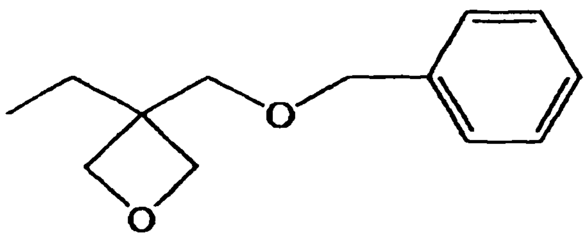

(23)

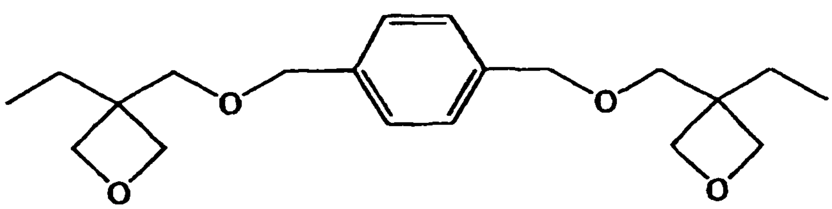

(24)

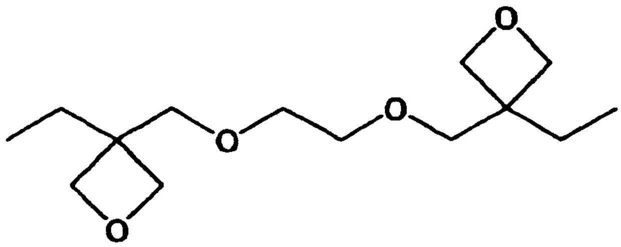

(25)

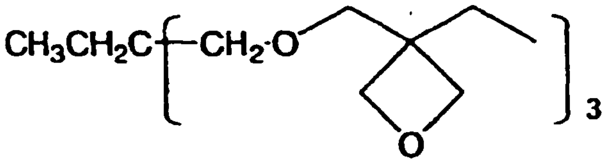

(26)

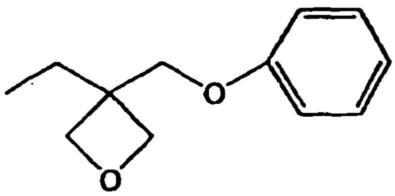

(27)

These oxetane compounds can be used either individually or in combinations of two or more.

The content of the component (A) in the resin composition of the present invention is 10-60 wt%.

If the content is too low, the cationic polymerization rate (curing rate) of the resulting resin composition decreases, whereby the fabrication may require a long period of time, or the resolution may decrease. If the content is too high, toughness of the cured product may be reduced or the cationic polymerization rate (curing rate) tends to decrease.

Component (B): epoxy compound

The photocurable resin composition of the present invention comprises an epoxy compound. The epoxy compound used in the present invention has a three-membered epoxyethane structure and does not include a structure with four members or more such as an oxetane group. The epoxy compound used in the present invention contains a glycidyl group or epoxycyclohexyl group in the molecule. The number of epoxyethane structures included in the epoxy compound is one or more, preferably 2-15, and still more preferably 2-8 per molecule.

In the present invention, the combined use of the epoxy compound together with the oxetane compound (A) increases the photocuring rate, specifically, improves curability.

As the epoxy compound (B) used in the present invention, compounds containing an epoxycyclohexyl group and compounds containing a glycidyl group are preferable. The epoxycyclohexyl group-containing compounds exhibit superior cationic polymerizability. The glycidyl group-containing compounds provide a polymer with flexibility and increase the mobility of the polymerization system, thereby further improving curability.

Examples of the epoxycyclohexyl group-containing compounds include 3,4-epoxycyclohexylmethyl-3',4'-epoxycyclohexanecarboxylate, 2-(3,4-epoxycyclohexyl-5,5-spiro-3,4-epoxy)cyclohexane-metadioxane, bis(3,4-epoxycyclohexylmethyl)adipate, bis(3,4-epoxy-6-methylcyclohexylmethyl)adipate, 3,4-epoxy-6-methylcyclohexyl-3',4'-epoxy-6'-methylcyclohexanecarboxylate, methylenebis(3,4-epoxycyclohexane), di(3,4-epoxycyclohexylmethyl) ether of ethylene glycol, ethylenebis(3,4-epoxycyclohexanecarboxylate, ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, β-methyl-δ-valerolactone-modified 3,4-epoxycyclohexylmethyl-3',4'-epoxycyclohexanecarboxylate.

Of these, 3,4-epoxycyclohexylmethyl-3',4'-epoxycyclohexanecarboxylate, bis(3,4-epoxycyclohexylmethyl)adipate, ε-caprolactone-modified 3,4-epoxycyclohexylmethyl-3',4'-epoxycyclohexanecarboxylate, trimethylcaprolactone-modified 3,4-epoxycyclohexylmethyl-3',4'-epoxycyclohexanecarboxylate, and β-methyl-δ-valerolactone-modified 3,4-epoxycyclohexylmethyl-3',4'-epoxycyclohexanecarboxylate are preferable. 3,4-epoxycyclohexylmethyl-3',4'-epoxycyclohexanecarboxylate and bis(3,4-epoxycyclohexylmethyl)adipate are particularly preferable.

As commercially available products suitably used as these compounds, UVR-6100, UVR-6105, UVR-6110, UVR-6128, UVR-6200, UVR-6216 (manufactured by Union Carbide Corp.), Celoxide 2021, Celoxide 2021P, Celoxide 2081, Celoxide 2083, Celoxide 2085, Epolead GT-300, Epolead GT-301, Epolead GT-302, Epolead GT-400, Epolead

401, Epolead 403 (manufactured by Daicel Chemical Industries, Ltd.), KRM-2100, KRM-2110, KRM-2199 (manufactured by Asahi Denka Kogyo Co., Ltd.), and the like can be given. These compounds can be used either individually or in combinations of two or more.

Examples of the glycidyl group-containing epoxy compounds suitably used as the component (B) include bisphenol A diglycidyl ether, bisphenol F diglycidyl ether, bisphenol S diglycidyl ether, brominated bisphenol A diglycidyl ether, brominated bisphenol F diglycidyl ether, brominated bisphenol S diglycidyl ether, hydrogenated bisphenol A diglycidyl ether, hydrogenated bisphenol F diglycidyl ether, hydrogenated bisphenol S diglycidyl ether, 1,4-butanediol diglycidyl ether, 1,6-hexanediol diglycidyl ether, glycerol triglycidyl ether, trimethylolpropane triglycidyl ether, polyethylene glycol diglycidyl ether, polypropylene glycol diglycidyl ether; polydiglycidyl ethers of polyether polyols obtained by the addition of one or more alkylene oxides to aliphatic polyhydric alcohols such as ethylene glycol, propylene glycol, and glycerol; diglycidyl esters of aliphatic long-chain dibasic acids; monodiglycidyl ethers of aliphatic higher alcohols; monodiglycidyl ethers of phenol, cresol, butyl phenol, or polyether alcohols obtained by the addition of alkylene oxide to these compounds; and glycidyl esters of higher fatty acids.

Of these, bisphenol A diglycidyl ether, bisphenol F diglycidyl ether, hydrogenated bisphenol A diglycidyl ether, hydrogenated bisphenol F diglycidyl ether, 1,4-butanediol diglycidyl ether, 1,6-hexanediol diglycidyl ether, glycerol triglycidyl ether, trimethylolpropane triglycidyl ether, neopentyl glycol diglycidyl ether, polyethylene glycol diglycidyl ether, and polypropylene glycol diglycidyl ether are preferable.

As commercially available products suitably used as the glycidyl group-containing compounds, UVR-6216 (manufactured by Union Carbide Corp.), Glycidole, AOEX24, Cyclomer A200 (manufactured by Daicel Chemical Industries, Ltd.), Epicoat 828, Epicoat 812, Epicoat 1031, Epicoat 872, Epicoat CT508 (manufactured by Yuka-Shell K.K.), KRM-2400, KRM-2410, KRM-2408, KRM-2490, KRM-2720, KRM-2750 (manufactured by Asahi Denka Kogyo Co., Ltd.), and the like can be given. These compounds can be used either individually or in combinations of two or more as the component (B).

The content of the component (B) used in the photocurable resin composition of the present invention is 20-70 wt%. If the content is too low, curability may be lowered. On the other hand, if the content is too high, viscosity of the resin composition increases, whereby the fabrication requires a long period of time.

<u>(C) Photoacid generator</u>

The Photoacid generator (C) used in the photocurable resin composition of the present invention (hereinafter may be called "component (C)") generates a substance which initiates cationic polymerization of the component (A) upon exposure to energy rays such as light. The energy ray such as light used herein refers to visible light, ultraviolet light, infrared light, X-rays, $\alpha$-rays, $\beta$-rays, $\gamma$-rays, and the like.

As examples of the compounds used as the component (C), an onium salt having a structure shown by the following formula (28) can be given. The onium salt liberates a Lewis acid upon exposure to light.

$$[R^{21}{}_{a}{}^{22}{}_{b}R^{23}{}_{c}R^{24}{}_{d}W]^{+m}\,[MX_{n+m}]^{-m} \qquad (28)$$

wherein the cation is an onium ion; W represents S, Se, Te, P, As, Sb, Bi, O, I, Br, Cl, or N=N; $R^{21}$, $R^{22}$, $R^{23}$, and $R^{24}$ represent individually the same or different organic group; a, b, c, and d independently represent an integer from 0 to 3, and provided that a+b+c+d is equal to the valence number of W. M represents a metal or metalloid which constitutes a center atom of a halide complex. Typical examples of M are B, P, As, Sb, Fe, Sn, Bi, Al, Ca, In, Ti, Zn, Sc, V, Cr, Mn, and Co. X represents a halogen atom such as a fluorine atom, chlorine atom, or bromine atom. m is a substantial electric charge of the halide complex ion and n is the valence of M.

Given as typical examples of the onium salts represented by the formula (28) are diphenyliodonium, 4-methoxydiphenyliodonium, bis(4-methylphenyl)iodonium, bis(4-tert-butylphenyl)iodonium, bis(dodecylphenyl)-iodonium, triphenylsulfonium, diphenyl-4-thiophenoxyphenylsulfonium, bis[4-(diphenylsulfonio)-phenyl]-sulfide, bis[4-(di(4-(2-hydroxyethyl)phenyl)sulfonio)-phenyl]sulfide, and $\eta^5$-2,4-(cyclopentadienyl)-[(1,2,3,4,5,6-$\eta$)-(methylethyl)-benzene]-iron (1+).

Given as specific examples of the negative ion ($MX_{n+m}$) in the above formula (28) are tetrafluoroborate ($BF_4^-$), hexafluorophosphate ($PF_6^-$), hexafluoroantimonate ($SbF_6^-$), hexafluoroarsenate ($AsF_6^-$), and hexachloroantimonate ($SbCl_6^-$).

Onium salts having an anion represented by $[MX_n(OH)^-]$ can be used. Moreover, onium salts having other anions such as a perchloric acid ion ($ClO_4^-$), trifluoromethanesulfonic acid ion ($CF_3SO_3^-$), fluorosulfonic acid ion ($FSO_3^-$), toluenesulfonic acid ion, trinitrobenzenesulfonic acid anion, and trinitrotoluenesulfonic acid anion can also be used.

Of these onium salts, aromatic onium salts are particularly effective as the photoacid generator of the component (C). For example, aromatic halonium salts disclosed in Japanese Patent Application Laid-open Nos. 151996/1975 and 158680/1975, VIA group aromatic onium salts disclosed in Japanese Patent Application Laid-open Nos. 151997/1975,

30899/1977, 55420/1981, and 125105/1980, VA group aromatic onium salts disclosed in Japanese Patent Application Laid-open No. 158698/1975, oxosulfoxonium salts disclosed in Japanese Patent Application Laid-open Nos. 8428/1981, 149402/1981, and 192429/1982, aromatic diazonium salts disclosed in Japanese Patent Application Laid-open No. 17040/1974, thiopyrylium salts disclosed in U.S. Patent No. 4,139,655, and the like are preferable. In addition, iron/allene complex initiators, aluminum complex/photolysis silicon compound initiators, and the like can also be given as examples.

As examples of commercially available products of the photoacid generator suitably used as the component (C), UVI-6950, UVI-6970, UVI-6974, UVI-6990 (manufactured by Union Carbide Corp.), Adekaoptomer SP-150, SP-151, SP-170, SP-171, SP-172 (manufactured by Asahi Denka Kogyo Co., Ltd.), Irgacure 261 (manufactured by Ciba Specialty Chemicals Co.), CI-2481, CI-2624, CI-2639, CI-2064 (manufactured by Nippon Soda Co., Ltd.), CD-1010, CD-1011, CD-1012 (manufactured by Sartomer Co., Ltd.), DTS-102, DTS-103, NAT-103, NDS-103, TPS-103, MDS-103, MPI-103, BBI-103 (manufactured by Midori Chemical Co., Ltd.), PCI-061T, PCI-062T, PCI-020T, PCI-022T (manufactured by Nippon Kayaku Co., Ltd.), and the like can be given. Of these, UVI-6970, UVI-6974, Adekaoptomer SP-170, SP-171, SP-172, CD-1012, and MPI-103 are particularly preferable, because high photocuring sensitivity can be provided in the resulting resin composition.

These photoacid generators can be used either individually or in combinations of two or more as the component (C).

The content of the component (C) used in the photocurable resin composition of the present invention is 0.2-6 wt%, and preferably 0.3-4 wt%. If the content of the component (C) is too low, photocurability of the resulting resin composition decreases, whereby a three-dimensional object exhibiting sufficient mechanical strength cannot be produced. On the other hand, if the content is too high, it becomes difficult to control cure depth of the resulting resin composition when used for photofabrication due to insufficient phototransmission, whereby the resulting three-dimensional objects may exhibit insufficient fabrication accuracy.

<u>Elastomer core-shell particles (D) with an average particle diameter of 10-700 nm</u>

The elastomer particles (D) with an average particle diameter of 10-700 nm used in the photocurable resin composition of the present invention (hereinafter may be called "component (D)") are elastomer core-shell particles as defined in claim 1.

The elastomer core-shell particles optionally with the assistance of crosslinking acids can be crosslinked by a conventional method. Examples of crosslinking acids used in such a method, divinylbenzene, ethylene glycol di(meth)acrylate, diallylmaleate, triallylcyanurate, triallylisocyanurate, diallylphthalate, trimethylolpropane triacrylate and allyl methacrylate.

The core-shell type particles are elastomer particles in which a core of partially crosslinked polybutadiene, polyisoprene, styrene/butadiene copolymer, styrene/isoprene copolymer, butadiene/(meth)acrylate copolymer, styrene/butadiene block copolymer, or styrene/isoprene block copolymer, is coated with a methyl methacrylate polymer, or methyl methacrylate/glycidyl methacrylate copolymer. The ratio of the core radius to the shell thickness of the core-shell type particles is usually from 1/2 to 1000/1, preferably from 1/1 to 200/1 (for example, if the core radius is 350 nm and the shell thickness is 10 nm, the ratio is expressed as 35/1).

These elastomer core-shell particles can be prepared by a conventional method such as emulsion polymerization. The emulsion polymerization can be carried out by, for example, polymerizing the total amount of a monomer component in one reaction, polymerizing part of a monomer component first and then continuously or intermittently adding the remaining part of the monomer component to polymerize, polymerizing a monomer component while continuously adding the monomer component during polymerization, or polymerizing a monomer component using seed particles.

The average particle diameter of the elastomer core-shell particles thus produced is 10-700 nm, and preferably 30-300 nm. If elastomer particles with an average particle diameter of less than 10 nm are used, not only may the resulting three-dimensional objects exhibit decreased impact resistance but also productivity and fabrication accuracy of the three-dimensional objects may be adversely affected due to the increased viscosity of the resin composition. On the other hand, if elastomer particles with an average particle diameter of more than 700 nm are used, the surface of the resulting three-dimensional object may become uneven or fabrication accuracy may decrease.

As examples of commercially available products of these core-shell type elastomer particles, Resinous Bond RKB (manufactured by Resinous Chemical Industries Co., Ltd.), Techno MBS-61, MBS-69 (manufactured by Techno Polymer Co., Ltd.), and the like can be given.

These elastomer core-shell particles can be used either individually or in combinations of two or more as the component (D).

The content of the component (D) used in the photocurable resin composition of the present invention is 1-35 wt%, preferably 3-30 wt%, and particularly preferably 5-20 wt%. If the content of the component (D) is too low, the resulting three-dimensional object may exhibit decreased impact resistance. On the other hand, if the content is too

high, the resulting three-dimensional object may exhibit decreased fabrication accuracy.

Component (E): polyol

The polyol (E) used in the photocurable resin composition of the present invention as an optional component (hereinafter may be called "component (E)") is useful for providing photocurability in the resin composition as well as form stability (controlling deformation with time) and physical stability (controlling change in mechanical characteristics with time) for the photofabricated three-dimensional objects. The polyol used as the component (E) contains preferably two or more, and still more preferably from 2 to 6 hydroxyl groups in one molecule. If a polyol containing less than two hydroxyl groups in one molecule is used, photocurability of the resin composition may not be sufficiently improved, and mechanical characteristics, in particular, the modulus of elasticity of the resulting three-dimensional objects may decrease. If a polyol containing more than six hydroxyl groups in one molecule is used, the resulting three-dimensional objects may exhibit insufficient elongation and reduced moisture resistance.

As examples of such polyols, polyether polyols, polycaprolactone polyols, polyester polyols produced by modifying with polyester consisting of dibasic acid and diols, and the like can be given.

Of these, polyether polyols are preferable. For example, polyether polyols formed by modifying polyhydric alcohols containing three or more hydroxyl groups such as trimethylolpropane, glycerol, pentaerythritol, sorbitol, and sucrose, quadrol with a cyclic ether compound such as ethylene oxide (hereinafter may be called "EO"), propylene oxide (hereinafter may be called "PO"), butylene oxide, and tetrahydrofuran can be given as examples. Specific examples include EO-modified trimethylolpropane, PO-modified trimethylolpropane, tetrahydrofuran-modified trimethylolpropane, EO-modified glycerol, PO-modified glycerol, tetrahydrofuran-modified glycerol, EO-modified pentaerythritol, PO-modified pentaerythritol, tetrahydrofuran-modified pentaerythritol, EO-modified sorbitol, PO-modified sorbitol, EO-modified sucrose, PO-modified sucrose, EO-modified quadrol, polyoxyethylenediol, polyoxypropylenediol, polyoxytetramethylenediol, polyoxybutylenediol, polyoxybutylene-oxyethylene copolymer diol, and the like. Of these, EO-modified trimethylolpropane, PO-modified trimethylolpropane, PO-modified glycerol, and PO-modified sorbitol are preferable.

As examples of commercially available products of the polyether polyols used as the component (E), Sunnix TP-400, GP-600, GP-1000, SP-750, GP-250, GP-400, GP-600 (manufactured by Sanyo Chemical Industries, Ltd.), TMP-3 Glycol, PNT-4 Glycol, EDA-P-4, EDA-P-8 (manufactured by Nippon Nyukazai Co., Ltd.), G-300, G-400, G-700, T-400, EDP-450, SP-600, SC-800 (manufactured by Asahi Denka Kogyo Co., Ltd.), and the like can be given.

As specific examples of the polycaprolactone polyols, caprolactone-modified trimethylolpropane, caprolactone-modified glycerol, caprolactone-modified pentaerythritol, caprolactone-modified sorbitol, and the like can be given.

Examples of commercially available products of the polycaprolactone polyol include TONE 0301, TONE 0305, TONE 0310 (manufactured by Union Carbide Corp.), and the like. Examples of commercially available products of the polyester polyol include PLACCEL 303, PLACCEL 305, PLACCEL 308 (manufactured by Daicel Chemical Industries, Ltd.), and the like.

These polyols can be used either individually or in combinations of two or more as the component (E).

The molecular weight of the polyol used as the component (E) is preferably 100-50,000, and still more preferably 160-20,000. If the molecular weight of the polyol used as the component (E) is too small, the three-dimensional object exhibiting form stability and physical stability cannot be formed depending on the resulting resin composition. If the molecular weight of the polyol is too great, viscosity of the resin composition may increase, thereby reducing the modulus of elasticity of the photofabricated three-dimensional objects.

The content of the component (E) used in the photocurable resin composition of the present invention is 0-25 wt%. If the content of the component (E) is too great, photocurability of the resin composition may decrease, thereby reducing the modulus of elasticity of the resulting three-dimensional objects.

Ethylenically unsaturated monomer (F)

The ethylenically unsaturated monomer (F) optionally used in the photocurable resin composition of the present invention (hereinafter may be called "component (F)") contains an ethylenically unsaturated bond (C=C) in the molecule. As examples of the component (F), monofunctional monomers containing one ethylenically unsaturated bond in one molecule and polyfunctional monomers containing two or more, and preferably three or more ethylenically unsaturated bonds in one molecule can be given.

Examples of the monofunctional monomers suitably used as the component (F) include acrylamide, (meth)acryloylmorpholine, 7-amino-3,7-dimethyloctyl (meth)acrylate, isobutoxymethyl(meth)acrylamide, isobornyloxyethyl (meth)acrylate, isobornyl (meth)acrylate, 2-ethylhexyl (meth)acrylate, ethyldiethylene glycol (meth)acrylate, t-octyl (meth)acrylamide, diacetone (meth)acrylamide, dimethylaminoethyl (meth)acrylate, diethylaminoethyl (meth)acrylate, lauryl (meth)acrylate, dicyclopentadiene (meth)acrylate, dicyclopentenyloxyethyl (meth)acrylate, dicyclopentenyl (meth)acrylate, N,N-dimethyl(meth)acrylamidetetrachlorophenyl (meth)acrylate, 2-tetrachlorophenoxyethyl (meth)acrylate, tetrahydrofurfuryl (meth)acrylate, tetrabromophenyl (meth)acrylate, 2-tetrabromophenoxyethyl (meth)acrylate, 2-trichlorophenoxyethyl (meth)acrylate, tribromophenyl (meth)acrylate, 2-tribromophenoxyethyl (meth)acrylate, 2-hydroxyethyl (meth)acrylate, 2-hydroxypropyl (meth)acrylate, vinylcaprolactam, N-vinylpyrrolidone, phenoxyethyl (meth)acrylate, butoxyethyl (meth)acrylate, pentachlorophenyl (meth)acrylate, pentabromophenyl (meth)acrylate, polyethylene glycol mono(meth)acrylate, polypropylene glycol mono(meth)acrylate, bornyl (meth)acrylate, methyltriethylene diglycol (meth)acrylate, and compounds shown by the following formulas (29)-(31).

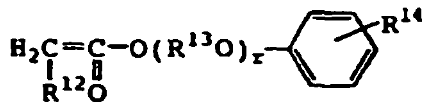

(29)

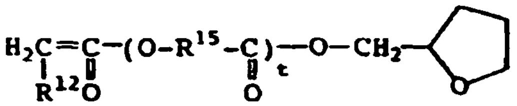

(30)

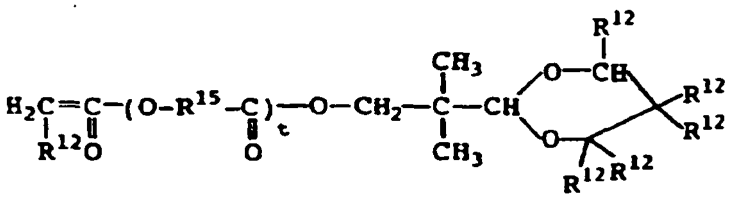

(31)

wherein $R_{12}$ = H, Me
$R_{13}$ and $R_{15}$ are alkylene groups having 1-20 C-atoms
$R_{14}$ = H or alkylene group having 1-20 C-atoms
r, t are integers from 0 to 100

Of these monofunctional monomers, isobornyl (meth)acrylate, lauryl (meth)acrylate, and phenoxyethyl (meth)acrylate are particularly preferable.

As examples of commercially available products of these monofunctional monomers, ARONIX M-101, M-102, M-111, M-113, M-11 7, M-152, TO-1210 (manufactured by Toagosei Co., Ltd.), KAYARAD TC-110S, R-564, R-128H (manufactured by Nippon Kayaku Co., Ltd.), Viscoat 192, 220, 2311HP, 2000, 2100, 2150, 8F, 17F (manufactured by Osaka Organic Chemical Industry Co., Ltd.), and the like can be given.

Examples of the polyfunctional monomers suitably used as the component (F) include ethylene glycol di(meth)acrylate, dicyclopentenyl di(meth)acrylate, triethylene glycol diacrylate, tetraethylene glycol di(meth)acrylate, tricyclodecanediyldimethylene di(meth)acrylate, tris(2-hydroxyethyl)isocyanurate di(meth)acrylate, tris(2-hydroxyethyl)isocyanurate tri(meth)acrylate, caprolactone-modified tris(2-hydroxyethyl)isocyanurate tri(meth)acrylate, trimethylolpropane tri(meth)acrylate, ethylene oxide (hereinafter may be abbreviated as "EO") modified trimethylolpropane tri(meth)acrylate, propylene oxide (hereinafter may be abbreviated as "PO") modified trimethylolpropane tri(meth)acrylate, tripropylene glycol di(meth)acrylate, neopentyl glycol di(meth)acrylate, both-terminal (meth)acrylic acid adduct of bisphenol A diglycidyl ether, 1,4-butanediol di(meth)acrylate, 1,6-hexanediol di(meth)acrylate, pentaerythritol tri(meth)acrylate, pentaerythritol tetra(meth)acrylate, polyester di(meth)acrylate, polyethylene glycol di(meth)acrylate, dipentaerythritol hexa(meth)acrylate, dipentaerythritol penta(meth)acrylate, dipentaerythritol tetra(meth)acrylate, caprolactone-modified dipentaerythritol hexa(meth)acrylate, caprolactone-modified dipentaerythritol penta(meth)acrylate, ditrimethylolpropane tetra(meth)acrylate, EO-modified bisphenol A di(meth)acrylate, PO-modified bisphenol A di(meth)acrylate, EO-modified hydrogenated bisphenol A di(meth)acrylate, PO-modified hydrogenated bisphenol A di(meth)acrylate, EO-modified bisphenol F di(meth)acrylate, (meth)acrylate of phenol novolak polyglycidyl ether, and the like.

As examples of commercially available products of these polyfunctional monomers, SA 1002 (manufactured by Mitsubishi Chemical Corp.), Viscoat 195, 230, 260, 215, 310, 214HP, 295, 300, 360, GPT, 400, 700, 540, 3000, 3700 (manufactured by Osaka Organic Chemical Industry Co., Ltd.), KAYARAD R-526, HDDA, NPGDA, TPGDA, MANDA, R-551, R-712, R-604, R-684, PET-30, GPO-303, TMPTA, THE-330, DPHA, DPHA-2H, DPHA-2C, DPHA-2I, D-310, D-330, DPCA-20, DPCA-30, DPCA-60, DPCA-120, DN-0075, DN-2475, T-1420, T-2020, T-2040, TPA-320, TPA-330, RP-1040, RP-2040, R-011, R-300, R-205 (manufactured by Nippon Kayaku Co., Ltd.), ARONIX M-210, M-220, M-233, M-240, M-215, M-305, M-309, M-310, M-315, M-325, M-400, M-6200, M-6400 (manufactured by Toagosei Co., Ltd.), Lite Acrylate BP-4EA, BP-4PA, BP-2EA, BP-2PA, DCP-A (manufactured by Kyoeisha Chemical Co., Ltd.), New Frontier

BPE-4, TEICA, BR-42M, GX-8345 (manufactured by Daiichi Kogyo Seiyaku Co., Ltd.), ASF-400 (manufactured by Nippon Steel Chemical Co., Ltd.), Lipoxy SP-1506, SP-1 507, SP-1 509, VR-77, SP-4010, SP-4060 (manufactured by Showa Highpolymer Co., Ltd.), NK Ester A-BPE-4 (manufactured by Shin-Nakamura Chemical Co., Ltd.), and the like can be given.

Each of the above monofunctional and polyfunctional monomers can be used either individually or in combinations of two or more, or in combinations of at least one monofunctional monomer and at least one polyfunctional monomer as the component (F). It is preferable that 60 wt% or more of the component (F) consists of the polyfunctional monomers having three or more ethylenically unsaturated bonds in one molecule. The percentage of the polyfunctional monomers of component (F) having three or more ethylenically unsaturated bonds is more preferably 70 wt% or more, even more preferably 80 wt% or more, and particularly preferably 100 wt%. If the content of these polyfunctional monomers is less than 60 wt%, photocurability of the resin composition may decrease and the resulting three-dimensional objects tends to exhibit deformation with time.

These polyfunctional monomers having three or more ethylenically unsaturated bonds can be selected from the group consisting of the above-mentioned tri(meth)acrylate compounds, tetra(meth)acrylate compounds, penta(meth)acrylate compounds, and hexa(meth)acrylate compounds. Of these, trimethylolpropane tri(meth)acrylate, EO-modified trimethylolpropane tri(meth)acrylate, dipentaerythritol hexa(meth)acrylate, dipentaerythritol penta(meth)acrylate, and ditrimethylolpropane tetra(meth)acrylate are particularly preferable.

The content of the component (F) used in the photocurable resin composition of the present invention is 3-35 wt%, and preferably 5-10 wt%. If the content of the component (F) is too low, the resulting resin composition may exhibit decreased photocurability, whereby the three-dimensional object exhibiting sufficient mechanical strength cannot be formed. If the content is too high, the resulting resin composition may exhibit shrinkage during photocuring and the resulting three-dimensional objects may exhibit insufficient heat resistance and decreased moisture resistance.

Radical photopolymerization initiator (G)

The radical photopolymerization initiator (G) of the photocurable resin composition of the present invention (hereinafter also called "component (G)") decomposes by exposure to energy rays such as light to initiate the radical polymerization of the component (G) with radicals. The energy ray such as light used herein refers to visible light, ultraviolet light, infrared light, X-rays, $\alpha$-rays, $\beta$-rays, $\gamma$-rays, and the like.

Specific examples of the radical photopolymerization initiators used as the component (G) include acetophenone, acetophenone benzyl ketal, anthraquinone, 1-(4-isopropylphenyl)-2-hydroxy-2-methylpropan-1-one, carbazole, xanthone, 4-chlorobenzophenone, 4,4'-diaminobenzophenone, 1,1-dimethoxydeoxybenzoin, 3,3'-dimethyl-4-methoxybenzophenone, thioxanethone compounds, 2-methyl-1-[4-(methylthio)phenyl]-2-morpholino-propan-2-one, 2-benzyl-2-dimethylamino-1-(4-morpholinophenyl)-butan-1-one, triphenylamine, 2,4,6-trimethylbenzoyldiphenylphosphine oxide, bis(2,6-dimethoxybenzoyl)-2,4,4-trimethylpentylphosphine oxide, benzyl methyl ketal, 1-hydroxycyclohexyl phenyl ketone, 2-hydroxy-2-methyl-1-phenylpropan-1-one, fluorenone, fluorene, benzaldehyde, benzoin ethyl ether, benzoin propyl ether, benzophenone, Michler's ketone, 3-methylacetophenone, 3,3',4,4'-tetra(t-butylperoxycarbonyl)benzophenone (BTTB), combinations of BTTB and dye sensitizers such as xanthene, thioxanthene, cumarin, and ketocumarin, and the like. Of these, benzyl dimethyl ketal, 1-hydroxycyclohexyl phenyl ketone, 2,4,6-trimethylbenzoyldiphenylphosphine oxide, 2-benzyl-2-dimethylamino-1-(4-morpholinophenyl)-butan-1-one, and the like are particularly preferable.

These radical photopolymerization initiators can be used either individually or in combinations of two or more as the component (G).

The content of the component (G) used in the photocurable resin composition of the present invention is 0.1-8 wt%. If the content is too low, the radical polymerization rate (curing rate) of the resulting resin composition may decrease, whereby the fabrication may require a long period of time or the resolution may be reduced. If the content is too high, an excess amount of the polymerization initiator may decrease the curing characteristics of the resin composition or adversely affect the moisture resistance or heat resistance of the resulting three-dimensional objects.

Other components

Photosensitizers (polymerization accelerator), reactive diluents, and the like can be added to the photocurable resin composition of the present invention as optional components other than the components (A)-(G), insofar as the effects of the resin composition are not impaired.

As examples of the photosensitizers, amine compounds such as triethanolamine, methyldiethanolamine, triethylamine, and diethylamine, thioxanethone, derivatives of thioxanethone, anthraquinone, derivatives of anthraquinone, anthracene, derivatives of anthracene, perylene, derivatives of perylene, benzophenone, benzoin isopropyl ether, and the like can be given. As the reactive diluents, cationically polymerizable substances which are copolymerizable with the components (A) and (B) and can decrease the viscosity of composition solution are preferable.

Moreover, various additives may be added to the photocurable resin composition of the present invention as other optional components insofar as the objects and effects of the present invention are not impaired. Examples of such additives include polymers or oligomers such as an epoxy resin, polyamide, polyamideimide, polyurethane, polybutadiene, polychloroprene, polyether, polyester, styrenebutadiene block copolymer, petroleum resin, xylene resin, ketone resin, cellulose resin, fluorine-containing oligomer, silicone-containing oligomer, and polysulfide oligomer, polymerization inhibitors such as phenothiazine and 2,6-di-t-butyl-4-methylphenol, polymerization initiation adjuvant, leveling agents, wettability improvers, surfactants, plasticizers, UV absorbers, silane coupling agents, inorganic fillers, pigments, dyes, and the like.

The photocurable resin composition of the present invention can be produced by mixing the above components (A)-(G) homogeneously together with the optional components as required.

Viscosity of the photocurable resin composition at 25°C is preferably 50-2,000 cps (mPa.sec), and still more preferably 70-1,500 cps (mPa.sec).

The photocurable liquid resin composition of the present invention thus produced is suitably used as a photocurable liquid resin material for the photofabrication of three-dimensional objects. In the photofabrication, the photocurable resin composition of the present invention is provided with energy required for curing by being selectively irradiated with light such as visible light, ultraviolet light, or infrared light to form a three-dimensional object with a desired shape.

As the means of selectively irradiating the photocurable resin composition, various means can be employed without specific limitations. For example, a means of irradiating the composition while scanning with laser beams or focused rays converged by lenses, mirrors, and the like, a means of irradiating the composition with unfocused rays via a mask having a phototransmission area with a specified pattern, a means of irradiating the composition via optical fibers corresponding to a specified pattern of a photoconductive material comprising bundled multiple optical fibers, and the like can be employed. A mask which electrooptically forms a mask image consisting of a phototransmission area and a non-phototransmission area in accordance with a specified pattern by the same principle as that of a liquid crystal display can be used. If minute parts or high dimensional accuracy are required in the objective three-dimensional object, a means of scanning with laser beams with a small spot diameter is preferably employed.

The surface of the resin composition in a vessel to be irradiated (for example, scanning plane of focused rays) may be the liquid surface of the resin composition or the interface between the resin composition and the wall of the vessel. In the latter case, the composition can be irradiated either directly or indirectly via the wall of the vessel.

In the photofabrication of three-dimensional objects, after curing a predetermined area of the resin composition, the cured area is laminated by continuously or gradually moving the irradiation spot (irradiation surface) from the cured area to the uncured area to form an objective three-dimensional object. The irradiation spot can be moved by, for example, moving any one of a light source, vessel of the resin composition, or the cured area of the resin composition, or providing additional resin composition to the vessel.

A typical example of the photofabrication is as follows. The resin composition is provided on a support stage capable of moving up and down placed inside the container and is minutely lowered (submerged) to form a thin layer (1) of the resin composition. This thin layer (1) is selectively irradiated to form a solid cured resin layer (1). The liquid resin composition is provided on this cured resin layer (1) to form a thin layer (2). This thin layer (2) is selectively irradiated to form a cured resin layer (2) integrally laminated on the cured resin layer (1). This step is repeated for a certain number of times while using either the same or different irradiation patterns to form a three-dimensional object consisting of integrally laminated cured resin layers (n) .

The resulting three-dimensional object is then removed from the vessel. After the residual unreacted resin composition remaining on the surface is removed, the three-dimensional object is optionally washed. As washing agents, alcohol-type organic solvents such as isopropyl alcohol and ethyl alcohol, ketone-type organic solvents such as acetone, ethyl acetate, and methyl ethyl ketone, aliphatic organic solvents represented by terpenes, and low-viscosity heat curable or photocurable resins can be given.

When fabricating a three-dimensional object having surface smoothness, it is preferable to wash the surface of the three-dimensional object using a heat curable or photocurable resin. In this case, postcure by irradiating with heat or light is required in accordance with the type of curable resin used for washing. Since not only the resins on the surface of the object but also the uncured resin composition remaining inside the three-dimensional objects can be cured by the postcure, it is also preferable to perform the postcure after washing with organic solvents.

Furthermore, it is preferable to coat the surface of the three-dimensional object with heat curable or photocurable hard coatings in order to improve the surface hardness and heat resistance of the three-dimensional objects after washing the object. As such hard coating materials, organic coatings such as an acrylic resin, epoxy resin, and silicone resin or inorganic hard coatings can be used. These hard coatings can be used either individually or in combinations of two or more.

The three-dimensional object formed by photocuring the photocurable resin composition for photofabrication of three-dimensional objects of the present invention exhibits superior fabrication accuracy, a large modulus of elasticity, and excellent folding endurance with little change over time. Therefore, the three-dimensional object can be suitably used as mechanical parts, machine housings, and prototypes for such products.

## Examples

The present invention will be described in detail by examples, which should not be construed as limiting the present invention.

## Example 1

A stirrerwas charged with 50 parts by weight of 1,4-bis(3-ethyl-3-oxetanylmethoxy)methylbenzene (Component (A)), 2 parts by weight of triallylsulfonium hexafluoroantimonate (UVI-6974: manufactured by Union Carbide Corp.) (Component (C)), 8 parts by weight of elastomer particles with an average particle diameter of 200 nm produced by emulsion polymerization (core: partially crosslinked styrene/butadiene copolymer, shell: methyl methacrylate/glycidyl methacrylate) (Component (D)), 30 parts by weight of 3,4-epoxycyclohexylmethyl-3',4'-epoxycyclohexanecarboxylate (UVR-6110: manufactured by Union Carbide Corp.) (component B1), 10 parts by weight 1,6-hexanediol diglycidyl ether (Epolite 1600: manufactured by Kyoeisha Chemical Co., Ltd.) (Component (B)). The mixture was stirred at 60°C for 3 hours to prepare the photocurable liquid resin composition.

## Example 2-8 and Comparative Example 1-4

Photocurable resin compositions were prepared in the same manner as in Example 1 except the components (A)-(G) were stirred and mixed according to the formulations shown in Table 1. The values for each component in Table 1 are given in "part(s) by weight". The viscosity of all the resin compositions of the Examples and Comparative Examples were suitable for the photofabrication of three-dimensional objects.

| Component | | Example | | | | | | | | Comparative example | | | |
|---|---|---|---|---|---|---|---|---|---|---|---|---|---|
| | | 1* | 2* | 3* | 4* | 5* | 6* | 7* | 8 | 1 | 2 | 3 | 4 |
| A | Oxetane compound *1 | 50 | 40 | 30 | 50 | 30 | 30 | 40 | 30 | 90 | 50 | - | 15 |
| | Oxetane compound *2 | - | - | - | - | - | 10 | - | - | - | - | - | - |
| B | Epoxycyclohexane *6 | 30 | 30 | 30 | 30 | 30 | 30 | 30 | 30 | 8 | 38 | 60 | 14 |
| | Epoxycyclohexane *7 | - | 10 | 15 | 10 | 15 | 10 | 5 | - | - | - | 15 | - |
| | 1,6-hexanediol diglycidyl ether | 10 | 10 | 15 | - | - | - | 10 | - | - | 10 | 15 | - |
| | Neopentyl glycol glycidyl ether | - | - | - | - | 15 | 10 | - | 15 | - | - | - | - |
| C | Photoacid generator *3 | 2 | 2 | 2 | 2 | 2 | 2 | 2 | 2 | 2 | 2 | 2 | 2 |
| D | Elastomer particles 200 nm *4 | 8 | 8 | 8 | 8 | - | 8 | 6 | 8 | - | - | 8 | 8 |
| | Elastomer particles 50 nm -5 | - | - | - | - | 8 | - | - | - | - | - | - | - |
| E | Propylene oxide-modified glycerol *8 | - | - | - | - | - | - | 5 | - | - | - | - | - |
| F | Trimethylolpropane triacrylate | - | - | - | - | - | - | - | 14 | - | - | - | 60 |
| G | 1-hydroxy phenyl ketone | - | - | - | - | - | - | - | 1 | - | - | - | 1 |
| Property | | | | | | | | | | | | | |
| Curability | | Excellent | Excellent | Excellent | Excellent | Excellent | Excellent | Excellent | Excellent | Bad | Excellent | Bad | Excellent |
| Modulus of elasticity (after 1 day) | | 160 | 150 | 155 | 170 | 157 | 150 | 153 | 150 | 110 | 172 | 182 | 195 |

(continued)

| Component | Example | | | | | | | | Comparative example | | | |
|---|---|---|---|---|---|---|---|---|---|---|---|---|
| | 1* | 2* | 3* | 4* | 5* | 6* | 7* | 8 | 1 | 2 | 3 | 4 |
| Modulus of elasticity (after 30 days) | 155 | 146 | 150 | 165 | 152 | 146 | 148 | 154 | 120 | 165 | 170 | 210 |
| Folding endurance | ○ | ○ | ○ | ○ | ○ | ○ | ⊙ | ○ | ○ | × | × | × |
| Warping amount of fabricated object | Good | Excellent | Excellent | Good | Excellent | Excellent | Excellent | Excellent | Was not formed | Good | Was not formed | Bad |
| Fabrication accuracy | ○ | ⊙ | ⊙ | ○ | ⊙ | ⊙ | ⊙ | ⊙ | Was not formed | ○ | Was not formed | × |

Details of *1 to *8 in Table 1 are as follows.
*1: 1,4-bis(3-ethyl-3-oxetanylmethoxy)methylbenzene
*2: 3-ethyl [3-(phenoxy)methyl]oxetane
*3: Triallylsulfonium hexafluoroantimonate (UVI-6974: manufactured by Union Carbide Corp.)
*4: Elastomer particles with an average particle diameter of 200 nm produced by emulsion polymerization (core: partially crosslinked styrene/butadiene copolymer, shell: methyl methacrylate/glycidyl methacrylate)
*5: Elastomer particles with an average particle diameter of 50 nm produced by emulsion polymerization (core: partially crosslinked styrene/butadiene copolymer, shell: methyl methacrylate/glycidyl methacrylate)
*6: 3,4-epoxycyclohexylmethyl-3',4'-epoxycyclohexanecarboxylate (UVR-6110: manufactured by Union Carbide Corp.)
*7: Bis(3,4-epoxycyclohexylmethyl)adipate
*8: Propylene oxide-modified glycerol (Sunnix GP-400: manufactured by Sanyo Chemical Industries, Ltd.)

* Comparative example

Each photocurable resin composition prepared in Examples 1-8 and Comparative Examples 1-4 was evaluated according to the following method.

Curability

The photocurable resin composition was selectively irradiated using a photofabrication apparatus "Solid Creator JSC-2000" (manufactured by SONY Corp.) equipped with an Ar ion laser as a light source (wavelength: 351nm, 365nm) with a laser spot diameter of 200 μm and a laser power of 100 mW at the irradiation surface (liquid surface) while changing the scanning speed from 100 to 1,000 mm/second to measure a minimum energy value at which the resin composition is cured. The evaluation criteria were as follows. When the minimum energy value was less than 20 $mJ/cm^2$, curability was determined as "excellent"; when 20 to less than 30 $mJ/cm^2$, curability was determined as "good"; and when 30 $mJ/cm^2$ or more or when cured products were not produced, curability was determined as "bad".

MODULUS OF ELASTICITY

(1) Preparation of test specimen:

The composition was applied to a glass plate using an applicator to form a film with a thickness of 200 μm. The surface of the film was irradiated with UV light at a dose of 0.5 $J/cm^2$ using a conveyer curing apparatus equipped with a metal halide lamp to prepare a semi-cured resin film. The semi-cured resin film was peeled off the glass plate and put on a releasable paper. The side of the semi-cured resin film opposite to the previously irradiated side was then irradiated with UV light at a dose of 0.5 $J/cm^2$ to form a cured resin film.

The cured resin film thus prepared was allowed to stand under the following conditions to prepare test specimens ① and ②. Test specimen ①: Allowed to stand in a thermo-hygrostat at a temperature of 23°C and a relative humidity of 50% for 24 hours.
Test specimen ②: Allowed to stand in a thermo-hygrostat at a temperature of 23°C and a relative humidity of 50% for 30 days.

(2) Measurement:

Modulus of elasticity of each of the test specimen ① (for measurement of initial value) and test specimen ② (for measurement of change with time) was measured at a tensile rate of 1 mm/min and a bench mark distance of 25 mm in a thermo-hygrostat at a temperature of 23°C and a relative humidity of 50%.

Folding endurance

A cured resin film prepared under the same conditions as the test specimen ① for the measurement of modulus of elasticity was used as a test specimen. The folding endurance test was carried out by repeatedly folding the test specimen at a frequency of 60 times/sec. while applying a load of 1 kgf using an MIT folding endurance tester to measure the number of folds until the test specimen broke. A test specimen which broke at the folded part after 30 or more folds was rated as "O", a test specimen which broke after 40 or more folds was rated as "⊙", a test specimen which broke after less than 25 folds was rated as "X", and a test specimen which broke after 26-29 folds was rated as "Δ".

AMOUNT OF WARPING OF THREE-DIMENSIONAL OBJECT

(1) Preparation of test specimen:

The photocurable resin composition was selectively irradiated with a laser beam with a laser power of 100 mW at the irradiation surface (liquid surface) and a scanning speed at which the cure depth of each composition is 0.3 mm using the above photofabrication apparatus (JSC-2000) to form a cured resin layer (thickness: 0.20 mm). This step was repeated to form a measurement model (hereinafter called "warping model") shown in Fig. 1 (1). The warping model was then removed from the photofabrication apparatus. The resin composition adhering to the surface of the warping model was wiped off and an excess resin composition was removed from the model by washing with a terpene solvent.

(2) Measurement:

A leg 11 of a warping model 10 was secured to a horizontal stand 20 as shown in Fig. 1 (2). The distance between the horizontal stand 20 and the bottom end of the leg 12 (uplifting amount) was evaluated as the warping

amount (initial value). The compositions were rated as "excellent", "good", or "bad" in the order of the warping amount.

Fabrication accuracy

Fabrication accuracy of the three-dimensional objects was evaluated by taking the dimensions of the three-dimensional objects formed from each liquid resin.

(1) Formation of three-dimensional object:

A test specimen shaped like an "H" was formed under the same conditions as in the above "Amount of warping of three-dimensional object". The three-dimensional objects were conditioned by being allowed to stand in a thermo-hygrostat at a temperature of 23°C and a relative humidity of 50% for 24 hours.

(2) Measurement of dimensional accuracy of three-dimensional object:

Dimensions A, B, and C shown in Fig. 2 of the three-dimensional objects were taken using a caliper graduated in 0.01 mm. The dimensional differences between A and B and between C and B were determined according to the following formulas (I) and (II).

$$\text{Dimensional difference between A and B} = (A-B) \quad \text{(I)}$$

$$\text{Dimensional difference between C and B} = (C-B) \quad \text{(II)}$$

Dimensional accuracy of the three-dimensional object was evaluated as follows.

- Both the absolute values of dimensional differences between A and B and between C and B were less than 0.1 mm: "⊙"
- One of the absolute values of dimensional differences between A and B and between C and B was less than 0.1 mm and the other was 0.1 or more but less than 0.2 mm: "O"
- Both the absolute values of dimensional differences between A and B and between C and B were 0.1 mm or more but less than 0.2 mm: "Δ"
- One of the absolute values of dimensional differences between A and B and between C and B was 0.2 mm or more, or no three-dimensional object was formed: "X"

As is clear from Table 1, cured products of the compositions according to Examples 1-8 excelled in curability and fabrication accuracy and exhibited a large modulus of elasticity, a small amount of warping, and, in particular, excellent folding endurance.

On the contrary, the composition of Comparative Example 1 in which the epoxy compound (B) was not used exhibited poor curability. Although the composition was not cured under the same curing conditions as the Examples, the composition was cured by taking time to measure the modulus of elasticity and folding endurance. As for the warping amount and fabrication accuracy of the three-dimensional object, the composition was referred to as "was not formed" because the composition was not cured under the same conditions as in the Example. A cured product of the composition of Comparative Example 2 in which the elastomer particles (D) were not used exhibited inferior folding endurance. The composition of Comparative Example 3 in which the oxetane compound (A) was not used exhibited poor curability. Although the composition was not cured under the same curing conditions as the Examples, the composition was cured by taking time to measure the modulus of elasticity and folding endurance. As for the warping amount and fabrication accuracy of the three-dimensional object, the composition was referred to as "was not formed" because the composition was not cured under the same conditions as in the Example. The composition of Comparative Example 4 in which an excess amount of the ethylenically unsaturated monomer (F) was used exhibited superior curability but the three-dimensional object exhibited a large amount of warping and inferior fabrication accuracy.

The photocurable resin composition of the present invention comprises elastomer particles and exhibits excellent photocurability. The cured product of the composition exhibited a high modulus of elasticity, of which the decrease after 30 days was at an acceptable level, and superior fabrication accuracy, and the three-dimensional object of the cured product exhibited a small amount of warping. In particular, the cured product of the photocurable resin composition

of the present invention exhibited remarkably superior folding endurance in comparison with conventional photocurable resins. Therefore, the photocurable resin composition can be suitably used for manufacturing three-dimensional objects such as prototypes for machine parts.

Fig. 1 is a diagram illustrating a model and a method for measuring a warping amount of cured products formed from photocurable compositions of the Examples and Comparative Examples.
Fig. 2 is a schematic view of a model for measuring fabrication accuracy (dimensional accuracy) of cured products formed from photocurable compositions of the Examples and Comparative Examples.

## Claims

1. Photocurable resin composition for photofabrication of three-dimensional objects comprising
an oxetane compound (A), wherein the content of the component (A) in the resin composition is 10-60 wt%,
an epoxy compound (B), wherein the content of the component (B) in the resin composition is 20-70 wt%,
a photoacid generator (C), wherein the content of the component (C) in the resin composition is 0.2-6 wt%,
elastomer particles (D), wherein the content of the component (D) in the resin composition is 1-35 wt%,
a polyol compound (E), wherein the content of the component (E) in the resin composition is 0-25 wt%,
an ethylenically unsaturated monomer (F), wherein the content of the component (F) in the resin composition is 3-35 wt%, and
a radical photopolymerisation initiator (G), wherein the content of the component (G) in the resin composition is 0.1-8 wt%,
wherein the elastomer particles (D) are core-shell particles having an average particle diameter of 10-700 nm and wherein the core is coated with a methyl methacrylate polymer or a methyl methacrylate/glycidyl methacrylate copolymer, and wherein the particles (D) are elastomer particles that have a core of partially crosslinked polybutadiene, polyisoprene, styrene/butadiene copolymer, styrene/isoprene copolymer, butadiene/(meth)acrylate copolymer, styrene/butadiene block copolymer, or styrene/isoprene block copolymer.

2. Photocurable resin composition according to claim 1, wherein the oxetane compound (A) contains two oxetane rings.

3. Photocurable resin composition according to claim 1, wherein the epoxy compound (B) contains an epoxycyclohexylgroup or glycidylgroup.

4. Photocurable resin composition according to claim 1, wherein the photoacid generator is an aromatic onium salt.

5. Photocurable resin composition according claim 1, wherein polyol (E) contains from 2 to 6 hydroxyl groups.

6. Use of the photocurable resin composition as defined in any one of the preceding claims in the photofabrication of three dimensional objects.

7. A three dimensional object obtainable by photofabrication of the photocurable resin composition as defined in claims 1-5.

8. Use of the three dimensional object as defined in claim 7 for prototypes for mechanical parts.

## Patentansprüche

1. Photohärtbare Harzzusammensetzung zur Photoherstellung von dreidimensionalen Gegenständen, umfassend
eine Oxetanverbindung (A), wobei der Gehalt an der Komponente (A) in der Harzzusammensetzung 10-60 Gew.-% beträgt,
eine Epoxidverbindung (B), wobei der Gehalt an der Komponente (B) in der Harzzusammensetzung 20-70 Gew.-% beträgt,
einen Photosäuregenerator (C), wobei der Gehalt an der Komponente (C) in der Harzzusammensetzung 0,2-6 Gew.-% beträgt,
elastomere Teilchen (D), wobei der Gehalt an der Komponente (D) in der Harzzusammensetzung 1-35 Gew.-% beträgt,
eine Polyolverbindung (E), wobei der Gehalt an der Komponente (E) in der Harzzusammensetzung 0-25 Gew.-%

beträgt,
ein ethylenischungesättigtes Monomer (F), wobei der Gehalt an der Komponente (F) in der Harzzusammensetzung 3-35 Gew.-% beträgt, und
einen Radikal-Photopolymerisationsinitiator (G), wobei der Gehalt an der Komponente (G) in der Harzzusammensetzung 0,1-8 Gew.-% beträgt,
wobei die elastomeren Teilchen (D) Kern-Schale-Teilchen mit einem durchschnittlichen Teilchendurchmesser von 10-700 nm sind und wobei der Kern mit einem Methylmethacrylatpolymer oder einem Methylmethacrylat/Glycidylmethacrylat-Copolymer beschichtet ist, und wobei die Teilchen (D) elastomere Teilchen sind mit einem Kern aus teilweise vernetztem Polybutadien, Polyisopren, Styrol/Butadien-Copolymer, Styrol/Isopren-Copolymer, Butadien/(Meth)acrylat-Copolymer, Styrol/Butadien-Blockcopolymer oder Styrol/Isopren-Blockcopolymer.

**2.** Photohärtbare Harzzusammensetzung nach Anspruch 1, wobei die Oxetanverbindung (A) zwei Oxetanringe enthält.

**3.** Photohärtbare Harzzusammensetzung nach Anspruch 1, wobei die Epoxidverbindung (B) eine Epoxycyclohexylgruppe oder Glycidylgruppe enthält.

**4.** Photohärtbare Harzzusammensetzung nach Anspruch 1, wobei der Photosäuregenerator ein aromatisches Oniumsalz ist.

**5.** Photohärtbare Harzzusammensetzung nach Anspruch 1, wobei das Polyol (E) 2 bis 6 Hydroxylgruppen enthält.

**6.** Verwendung der wie in einem der vorhergehenden Ansprüche definierten photohärtbaren Harzzusammensetzung zur Photoherstellung von dreidimensionalen Gegenständen.

**7.** Dreidimensionaler Gegenstand, erhältlich durch Photoherstellung der wie in den Ansprüchen 1-5 definierten photohärtbaren Harzzusammensetzung.

**8.** Verwendung des wie in Anspruch 7 definierten dreidimensionalen Gegenstands für Prototypen mechanischer Teile.

## Revendications

**1.** Composition de résine photodurcissable pour la photofabrication d'objets tridimensionnels comprenant
un composé oxétane (A), la teneur en le composant (A) dans la composition de résine étant de 10 à 60% en poids,
un composé époxy (B), la teneur en le composant (B) dans la composition de résine étant de 20 à 70% en poids,
un photogénérateur d'acide (C), la teneur en le composant (C) dans la composition de résine étant de 0,2 à 6% en poids,
des particules d'élastomère (D), la teneur en le composant (D) dans la composition de résine étant de 1 à 35% en poids,
un composé polyol (E), la teneur en le composant (E) dans la composition de résine étant de 0 à 25% en poids,
un monomère à insaturation éthylénique (F), la teneur en le composant (F) dans la composition de résine étant de 3 à 35% en poids, et
un amorceur de photopolymérisation radicalaire (G), la teneur en le composant (G) dans la composition de résine étant de 0,1 à 8% en poids,
dans laquelle les particules d'élastomère (D) sont des particules de type coeur-coquille ayant un diamètre moyen de particule de 10-700 nm et dans laquelle le coeur est revêtu d'un polymère de méthacrylate de méthyle ou d'un copolymère méthacrylate de méthyle/méthacrylate de glycidyle, et dans laquelle les particules (D) sont des particules d'élastomère qui ont un coeur de polybutadiène, de polyisoprène, de copolymère styrène/butadiène, de copolymère styrène/isoprène, de copolymère butadiène/(méth)acrylate, de copolymère séquencé styrène/butadiène ou de copolymère séquencé styrène/isoprène, partiellement réticulé.

**2.** Composition de résine photodurcissable selon la revendication 1, dans laquelle le composé oxétane (A) contient deux noyaux oxétane.

**3.** Composition de résine photodurcissable selon la revendication 1, dans laquelle le composé époxy (B) contient un groupe époxycyclohexyle ou un groupe glycidyle.

**4.** Composition de résine photodurcissable selon la revendication 1, dans laquelle le photogénérateur d'acide est un

sel d’onium aromatique.

5. Composition de résine photodurcissable selon la revendication 1, dans laquelle le polyol (E) contient de 2 à 6 groupes hydroxyle.

6. Utilisation de la composition de résine photodurcissable définie dans l’une quelconque des revendications précédentes dans la photofabrication d’objets tridimensionnels.

7. Objet tridimensionnel susceptible d’être obtenu par photofabrication de la composition de résine photodurcissable définie dans les revendications 1-5.

8. Utilisation de l’objet tridimensionnel défini dans la revendication 7 pour des prototypes pour des pièces mécaniques.

Explanation of Symbols

10: Warping model

11, 12: Leg

20: Horizontal stand

Drawing

[Fig. 1]

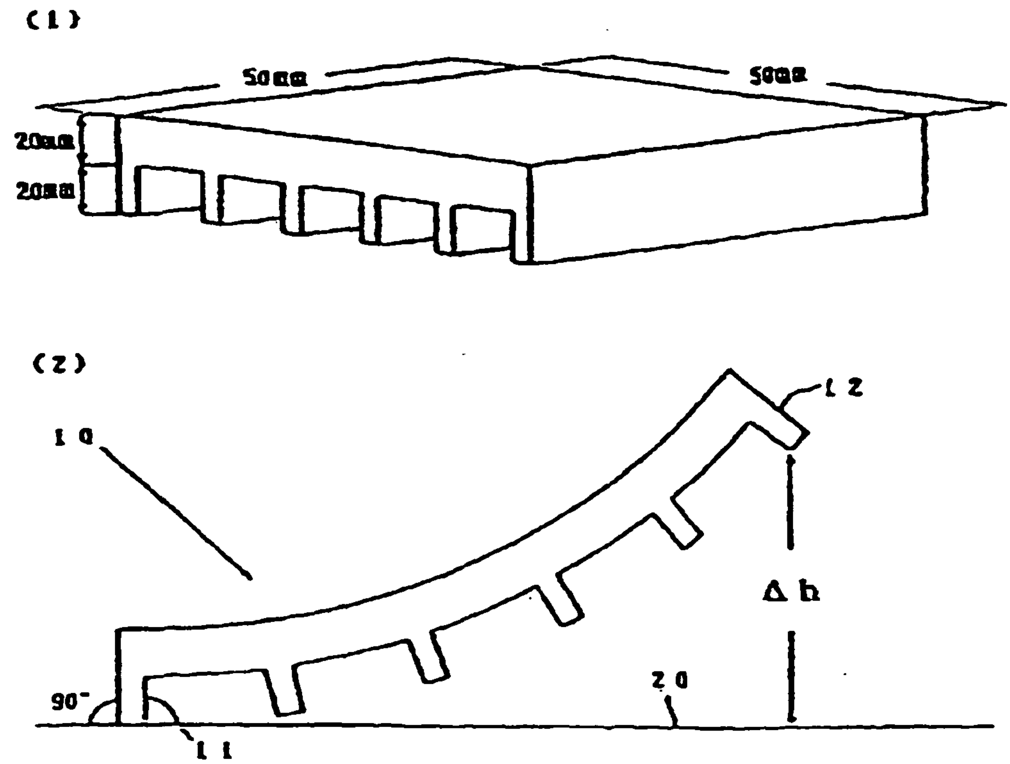

[Fig 2]

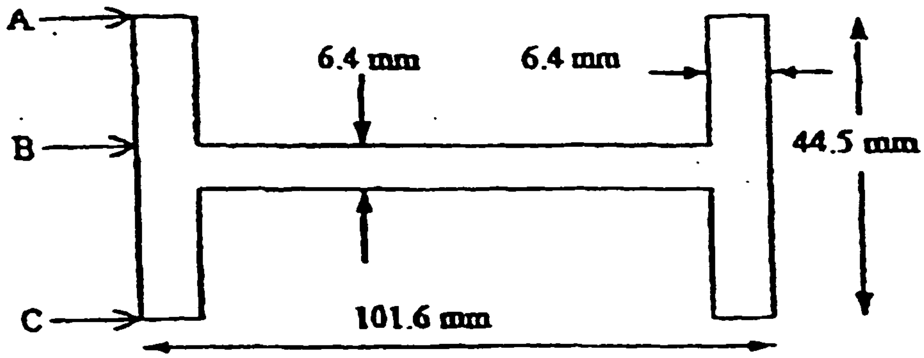

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 60247515 A
- JP 62035966 A
- JP 62101408 A
- JP 5024119 A
- JP 1204915 A
- JP 2208305 A
- JP 3160013 A
- JP 1213304 A
- JP 2028261 A
- JP 2075618 A
- JP 6228413 A
- JP 3114733 A
- JP 3103415 A
- JP 2145616 A
- JP 50151996 A
- JP 50158680 A
- JP 50151997 A
- JP 52030899 A
- JP 56055420 A
- JP 55125105 A
- JP 50158698 A
- JP 56008428 A
- JP 56149402 A
- JP 57192429 A
- JP 49017040 A
- US 4139655 A